# EUROPEAN PATENT APPLICATION

(11) **EP 0 562 754 A1**
(43) Date of publication of application: **29.09.1993**
(21) Application number: 93302001.8
(22) Date of filing: 17.03.1993
(51) Int. Cl.: H01S 3/025

(54) **Optical system for laser devices**

(30) Priority: 26.03.1992 US 857882
(71) Applicant: Hewlett-Packard Company, Palo Alto, California 94304 (US)
(72) Inventor: Gray, Damien F., Mountain View, California 94041 (US); Hopkins II, George W., Sunnyvale, California 94087 (US)
(74) Representative: Williams, John Francis

(57) **Abstract**

In coupling a laser (1) to external optical component(s) (5), a plano-convex lens (3) is attached to the front facet of the laser by application of an adhesive substance (2) that has a similar index of refraction as the lens. The combination of the lens and the adhesive substance forms an aplanatic optical system whereby the numerical aperture of the optical system is improved.

## Description

The present invention relates in general to laser devices and in particular to an optical system for providing external coupling for a semiconductor laser.

A laser is formed by first generating a population inversion in a laser medium through excitation of its atoms, molecules or ions into high quantum-mechanical energy levels. The population inversion provides coherent amplification to a beam of electromagnetic radiation as it passes through the medium. With proper feedback, the beam can be made to pass through the medium more than once to form coherent optical oscillations. If losses in the feedback are less than the amplification gained by passages through the medium, a beam that is both highly directional and highly monochromatic would result.

Feedback in laser devices can either be internal of or external to the medium. In semiconductor lasers, for example, the beam is usually made to oscillate back and forth within the active layer by cleaving opposite ends of the medium into a front facet and a rear facet, each of which is reflective to the laser beam. In laser devices using external feedback, the beam is made to pass through one or more external optical components.

The need to couple a laser beam with external optical components is not limited to situations where external feedback is used. Most laser devices need external optical components for their applications. Typical examples are optical components used for collimation and focusing.

When external optical components are used, it is desirable to minimize losses caused thereby so as to preserve overall efficiency of the laser devices. Laser rays are typically emitted with a certain angular divergence from the laser medium. In order to minimize losses, external optical components used for coupling a laser should preferably be able to collect as much of these rays as possible without aberrations, especially those higher order aberrations such as the spherical aberration and coma. But external optical components have a finite "light-gathering power", commonly measured in terms of its numerical aperture (defined as "the sine of the angular semi-aperture in the object space multiplied by the refractive index of the objective space" (see Born and Wolf, Principles of Optics, (Macmillan 1964), p.187)). In coupling a laser to external optical components, therefore, it is desirable to reduce the angular divergence of the beam output so that as much of the rays as possible can be collected by the external optical components.

In the aforementioned publication by Born and Wolf, a method is described for increasing the numerical aperture of an optical system (Id. at p. 253, see also Kingslake, Optical System Design, (Academic Press 1983), p. 189). According to the method, a plano-convex lens with a certain refractive index is immersed in a body of oil having a similar index of refraction as the lens. The combination of lens and oil forms an aplanatic optical system. (An aplanatic optical system is one that is free of both spherical aberration and coma). By placing the object at the closer aplanatic point of the lens-oil combination, the angular divergence of the rays is reduced without the introduction of aberrations.

In a publication entitled "Immersion Lens Assembly for Diode Laser", Anonymous Assignee, Research Disclosure 24231, 840610, WPI Acc. No. 84-174822/28, the above described method is applied to a semiconductor laser. According to the disclosed method, the diode laser is immersed in a chamber filled with a non-degrading, non-conductive liquid. The front wall of the chamber is a plastic lens whose index of refraction matches the index of refraction of the liquid. The combination forms an aplanatic optical system whereby the-angular divergence of the output beam from the laser can be reduced. To collimate the laser output, a second lens is inserted at the output of the lens-liquid assembly. The disclosure also suggests, however, the use of a liquid having an index of refraction higher than the index of refraction of the plastic lens so that this second lens can be eliminated.

As the laser diode is typically very small in comparison with the liquid chamber, this method is deemed impractical because of the difficulty in fitting the laser diode into a liquid-filled chamber. The method is also deemed undesirable because of difficulties in maintenance (e.g. cleaning, possibility of leakage of the liquid) of the laser device.

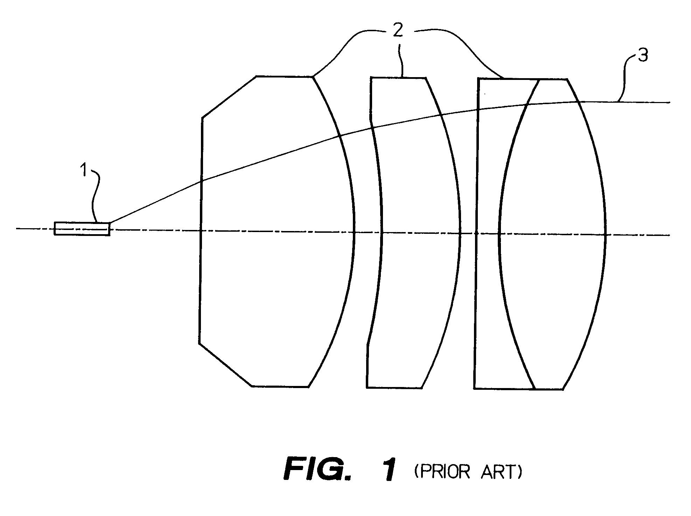

Because of these undesirable characteristics, there has been a desire in the art for an optical system that has a large numerical aperture, or can reduce angular divergence of light, without the need to use a liquid-filled chamber. One prior art optical system satisfying such requirements is the lens assembly shown in Fig. 1. Although using the lens assembly shown in Fig. 1 can eliminate the need for a liquid chamber, such prior art means is deemed undesirable because it requires at least three optical elements and is therefore relatively expensive.

### SUMMARY OF THE INVENTION

The aforementioned difficulties are eliminated in accordance with the present invention which is directed to an optical system comprising a laser, a lens and an adhesive substance adhering to both the laser and the lens.

By selecting an adhesive substance with the proper index of refraction, an aplanatic optical system can be formed to reduce the angular divergence of the rays from the output of the laser. When the adhesive substance selected has a substantially similar index of refraction as the lens in the preferred embodiment, a laser optical system with more predictable optical effects can be constructed even in view of the possibility that the thickness of adhesive substance (at a value of hundreds of angstroms) may not be controllable. (If the index of refraction is substantially different from that of the lens, deviations in the thickness of the adhesive substance would result in changes in effective reflectivity of the front facet of the laser.)

And by using an adhesive instead of a liquid-filled chamber, construction of the laser device becomes simpler and maintenance thereof becomes easier.

### BRIEF DESCRIPTION OF THE DRAWINGS

Fig. 1 is a schematic diagram of a typical prior art optical system for coupling a laser.

Fig. 2 is a schematic diagram of an optical system illustrating a preferred embodiment of the present invention.

### DESCRIPTION OF THE PREFERRED EMBODIMENT

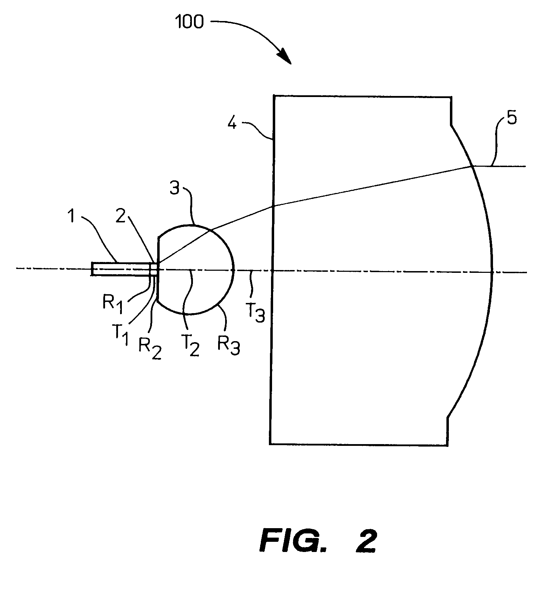

Fig. 2 is a diagram of a preferred embodiment of the present invention. It shows an optical system 100 comprising a semiconductor laser 1 and a plano-convex lens 3. The plano-convex lens 3 has a convex surface R3, a planar surface R2, and an axial thickness of T2 between the two surfaces. The planar surface R2 of the lens 3 is separated from the front facet R1 of laser 1 by an axial distance of T1. A transparent adhesive substance 2 is applied to the space between the front facet R1 of the laser 1 and the planar surface R2 of the lens 3. The adhesive substance 2 has an index of refraction, N1, substantially similar to the index of refraction, N2, of the lens 3. Output from the laser 1 passes through the adhesive substance 2 and lens 3 before it enter a collimating lens 4 which is separated from the plano-convex lens 3 by an axial distance of T3.

While a plano-convex lens is used as lens 3 in this preferred embodiment, those skilled in the art will understand that other lens can be also used to achieve the result intended herein, although a corresponding readjustment of the distance between the lens 3 and the laser 2 may become necessary. However, because controlling the thickness T1 of the adhesive substance is usually difficult, and because deviations in the thickness T1 would affect the performance of the optical system 100, T1 of the adhesive substance 2 should preferable remain small.

The values T1 and T2 are such that the front facet R2 of the laser 1 is positioned at or near the closer aplanatic point of the lens 3. Alternatively, if a specific separation T1 is desired, a lens of different value of N2 along with a different adhesive substance of different N1 may be used.

The plano-convex lens 3 should preferably have a large Abbe number so that dependency of its index of refraction on wavelengths is small.

In constructing the optical system 100, an amount of adhesive substance 2 is applied (for example, by a syringe) between the front facet of laser 1 and the lens 3. The amount of adhesive substance 2 used would depend on the value of T1 and the size of the front facet. Basically, sufficient amount of adhesive substance 2 should be applied to ensure that the rays from the laser 1 would pass through a uniform layer of adhesive substance 2 before they enter into the lens 3. However, the amount of adhesive substance 2 to be applied should preferably not be so excessive as to cause overflow when pressure is exerted between the lens 3 and the laser 1 in producing the separation T1.

After the adhesive substance 2 is applied, the laser 1 and the lens 3 are compressed until the separation T1 is attained. Compression to attain the correct separation T1 can also be preformed by using a specific pressure which is determined empirically. The pressure is maintained until the adhesive substance becomes stable. Where the adhesive is an epoxy, pressure is maintained until the epoxy is cured.

An optical system embodying the present invention has been constructed. In the specific construction, a Toshiba TOLD9211 semiconductor laser is used. The plano-convex lens is a lens from BAK4. Either Epoxy Technologies' EpoTek 301-2 or a cement from Norland Products Incorporated with a part number of NOA 61 can be used as the adhesive substance 2. Each of these two cements has an index of refraction substantially similar to the index of refraction of the BAK4 lens. The NOA 61 cement is an ultra-violet cure cement and has the advantage of being able to cure within a short time period (typically in seconds). The thickness of the adhesive substance is between 5 and 10 microns. A molded glass aspheric lens from Corning Incorporated with a part number of 350110 is used as the collimating lens 4. The parameters of the various components of the specific construction are:
Radius of curvature of the front facet R1 of the laser 1 = infinite
Separation T1 between the front facet R1 of laser 1 and the surface R2 of lens 3 = 0.006mm
Index of refraction N1 of the adhesive substance 2 = 1.564
Radius of curvature of the plano surface R2 of the lens 3 = infinite
Separation T2 between the plano surface R2 and the convex surface R3 of the lens 3 = 1.6182mm
Index of refraction N2 of the lens 3 = 1.569
Abbe number of the lens 3 = 56.13
Radius of curvature of the convex surface R3 of the lens 3 = -1.0000mm
Separation T3 between the surface R3 of lens 3 and surface of lens 4 = .826mm

Without the lens 3, the collimating lens 4 would have spherochromatism of ±0.02 waves at wavelength of 670nm, and about ±0.09 waves of residual spherical aberration. With the addition of lens 3 at the above listed parameters, the numerical aperture may be increased from 0.400 to 0.962 and the spherical aberration may be decreased to ±0.002 waves.

While the invention has been illustrated above in reference to particular implementations, components and parameters, it will further be understood that the such implementations, components and parameters may be varied and modified without departing from the invention whose scope is to be limited only by the following claims.

## Claims

1. An optical system comprising:
a semiconductor laser (1) having a front facet and a rear facet,
a lens (3), and
an adhesive substance (2) for adhering the lens to the front facet of the laser.

2. The optical system as in Claim 1, wherein said adhesive substance has a thickness of between five to ten microns.

3. The optical system as in Claim 1, wherein the lens is a positive lens.

4. The optical system as in Claim 3, wherein the lens is a plano-convex lens.

5. The optical system as in Claim 1, wherein said adhesive substance and said lens, in combination, form an aplanatic optical system for the laser.

6. An optical system for coupling to a laser (1) said laser having a front facet and a rear facet, said system comprising means for reducing angular divergency of rays from the laser, said reducing means comprising:
a lens (3), and
an adhesive substance (2) adhering to said lens and to the front facet of the laser.

7. A method for coupling a laser (1) to external optical components to form an optical system, said laser having a front facet and a rear facet, and emitting rays with an angular divergence, the method comprises:
providing a lens (3) having a predetermined index of refraction in front of the front facet of the laser, and
applying an adhesive substance (2) between said front facet of said laser and said lens whereby said lens in combination with said adhesive substance form an aplanatic optical system for the laser.

8. A method as in Claim 7, wherein the applying step comprising applying an adhesive substance having an substantially similar index of refraction as said predetermined index of refraction of said lens.

9. A method as in Claim 7, wherein said lens providing step provides a positive lens.

10. A method as in Claim 7, wherein said lens providing step provides a plano-convex lens.

11. A method as in Claim 7, further comprising the step of applying a pressure between the laser and the lens to adjust the thickness of said adhesive substance in forming said optical system.
